# EUROPEAN PATENT APPLICATION

(11) **EP 4 435 030 A1**
(43) Date of publication of application: **25.09.2024**
(21) Application number: 22895598.5
(22) Date of filing: 15.11.2022
(51) Int. Cl.: C08G 59/62, C08G 59/56, C08K 3/013, C08L 63/00, G02B 7/02

(54) **CURABLE RESIN COMPOSITION**

(30) Priority: 19.11.2021 JP 2021188312
(71) Applicant: Namics Corporation, Niigata-shi, Niigata 950-3131 (JP)
(72) Inventor: NAGATA, Rieko, Niigata-shi, Niigata 950-3131 (JP)
(74) Representative: Hoffmann Eitle
(86) International application number: PCT/JP2022/042374
(87) International publication number: WO 2023/090317

(57) **Abstract**

The present invention provides a curable resin composition which gives a cured product with lowered surface gloss and a sealing material comprising the same. The present invention also provides a cured product obtained by curing the curable resin composition or sealing material. The present invention also provides a camera module comprising the cured product.

## Description

### Technical Field

The present invention relates to a curable resin composition, a sealing material comprising the same, a cured product obtained by curing the same, and a camera module comprising the cured product.

### Background Art

Currently, in assembling and mounting a semiconductor device, such as a camera module, an adhesive, a sealing material and the like (hereinafter may be simply referred to as a "sealing material") comprising a curable resin composition, in particular an epoxy resin composition, are often used for such purposes as maintaining reliability.

Such an epoxy resin composition used as a sealing material for a semiconductor device generally comprises an epoxy resin and a curing agent. As an example of such a curable resin composition, there can be mentioned that disclosed in Patent Document 1. Curing of this curable resin composition can be achieved by heat treatment under appropriate conditions. Heat treatment for curing a curable resin composition is hereinafter also referred to as "thermal curing treatment".

Recent performance improvement of various portable devices brings demand for further performance improvement with respect to a camera mounted thereon. Suppression of flare is important for performance improvement of a camera. Flare refers to a phenomenon of unexpected appearance of light in an image and/or video (in which the light is not originally present) taken by a camera, as a result of unintended reflection of incident light into the camera occurred at the lens surface, the barrel or some other portion in the camera.

### Prior Art Documents

### Patent Documents

Patent Document 1: JP 2012-158730
Patent Document 2: JP 2014-156519
Patent Document 3: JP H10-275964

### Summary of Invention

### Problems to Be Solved by the Invention

As describe above, a sealing material is used in the production and mounting of a camera module. Conventionally, reflection of light from the cured product produced by curing of the sealing material has rarely been considered as a problem. However, because of recent enlargement of an image sensor used in a camera module mounted on a portable device, such as a smart phone and tablet computer, the sensor tends to be placed in a position close to this cured product. Further, demands for photographs and videos with higher picture quality are becoming increased. As a result, reflection of light on the surface of the cured product given by the sealing material is becoming a problem.

As an example of a conventional sealing material, there can be mentioned that disclosed in Patent Document 2. Many of such sealing materials give a cured product with glossy surface. As described above, there is a growing need for prevention of problems in a camera module, such as flare. Under this situation, therefore, desired is improvement of properties of a sealing material for lowering surface gloss of the cured product, which was conventionally rarely considered as a problem.

The present invention was made in view of the above-mentioned problems, and an object of the present invention is to provide a curable resin composition which gives a cured product with lowered surface gloss utilizing new mechanism, and a sealing material comprising the same. Another object of the present invention is to provide a cured product obtained by curing the curable resin composition or sealing material. A further object of the present invention is to provide a camera module comprising the cured product.

### Means to Solve the Problem

Under these circumstances, the present inventors carried out intensive research to develop a curable resin composition which gives a cured product with lowered surface gloss. As a result, it has unexpectedly been found that use of a latent curing agent in combination with a phenol-based curing agent as curing agents for curing an epoxy resin in a curable resin composition comprising a black colorant and a specific amount of a filler results in extremely lowered surface gloss of the cured product given by the curable resin composition. Based on the new findings above, the present invention has been completed.

That is, the present invention includes, but is not limited to, the following inventions.
1. A curable resin composition comprising:
   (A) an epoxy resin,
   (B) a latent curing agent,
   (C) a phenol-based curing agent,
   (D) a black colorant, and
   (E) a filler,
   wherein the amount of (E) filler is 20 to 60 % by volume, based on the total amount of the curable resin composition.
2. The curable resin composition according to item 1 above, which contains substantially no thiol compound.
3. The curable resin composition according to item 1 or 2 above, wherein [the total number of hydroxyl groups for (C) phenol-based curing agent] / [the total number of epoxy groups for (A) epoxy resin] is 0.1 or less.
4. The curable resin composition according to any one of items 1 to 3 above, wherein (B) latent curing agent comprises an imidazole compound and/or a tertiary amine compound.
5. The curable resin composition according to any one of items 1 to 4 above, wherein (B) latent curing agent is a microencapsulated latent curing agent.
6. The curable resin composition according to any one of items 1 to 5 above, wherein the amount of (E) filler is 35 % by volume or more, based on the total amount of the curable resin composition.
7. The curable resin composition according to any one of items 1 to 6 above, wherein the lowest viscosity determined by dynamic mechanical analysis under the conditions of the rate of temperature increase of 3 °C/minute and the temperature range of 25 °C to 120 °C is 1.5 Pa·s or more.
8. A sealing material comprising the curable resin composition of any one of items 1 to 7 above.
9. The sealing material according to item 8 above for sealing a wiring connecting an image sensor and a substrate in a camera module.
10. The sealing material according to item 8 or 9 above for preventing flare.
11. A cured product of the curable resin composition of any one of items 1 to 7 above or the sealing material of any one of items 8 to 10 above.
12. A camera module comprising the cured product of item 11 above.

### Effect of the Invention

The curable resin composition of the present invention comprises a latent curing agent in combination with a phenol-based curing agent as curing agents for curing an epoxy resin, as well as a black colorant and a specific amount of a filler. Therefore, the curable resin composition of the present invention gives a cured product with lowered surface gloss. Such a curable resin composition is extremely useful in the production of various semiconductor devices for use in which reflection of light on the surface of the cured product given by the composition may be a problem, especially a camera module.

### Brief Description of the Drawings

[FIG. 1] Figure 1 is an example of a cross-section of a camera module in which an image sensor is connected to a substrate by wire bonding method.
[FIG. 2] Figure 2 is an example of a cross-section of a camera module in which an image sensor is connected to a substrate by flip-chip bonding method.
[FIG. 3] Figure 3 is a graph showing the change in complex shear viscosity against the temperature during the determination of the complex shear viscosity with respect to the curable resin composition of each of Examples 1 to 6 and Comparative Examples 1 to 5 in accordance with the provisions of JIS K7244-10 under the conditions of the frequency of 1000 Hz, the distance of 0.500 mm between the parallel circular plates and the amount of strain of 0.5, while the temperature is increased from room temperature (25 °C) to 120 °C at the rate of temperature increase of 3 °C/minute.

### Description of Embodiments

The prevent invention is described below in detail.

As described above, the curable resin composition of the present invention comprises, as essential components, (A) an epoxy resin, (B) a latent curing agent, (C) a phenol-based curing agent, (D) a black colorant, and (E) a filler. Explanation is made below with respect to these (A) to (E).

As used herein, the term "resin" refers not only to a polymer (especially a synthetic polymer) but also molecules before curing used for producing a polymer. For example, an "epoxy resin" includes a material such as a monomer before curing which has an epoxy group.

As used herein, "camera" means a device for optical imaging equipped with an optical system for forming an image including a lens and the like, and the imaging wavelength range thereof includes the visible light range, infrared range and ultraviolet range. Therefore, the "camera" includes not only a camera mainly for imaging in the visible light range, such as that used in a device like a smart phone, tablet computer, laptop computer or the like, but also a camera for detection of a wavelength in the (near) infrared range, such as a thermal camera and a camera used in a ToF (Time of Flight) device for measuring the distance to an object, and the like. There is no particular limitation with respect to the use of the camera, and the camera is not limited to that for use in a device, such as a smart phone, and may be for automobile use, for use in tallying (surveying) / inspection in a factory, for use in monitoring of inside and/or outside of a building, and the like. As used herein, a "camera module" is a device which is the modularized main part of the above-mentioned camera.

### (A) Epoxy resin

The curable resin composition of the present invention comprises an epoxy resin.

Epoxy resins are roughly classified into monofunctional epoxy resins and polyfunctional epoxy resins. In the present invention, it is preferred that the epoxy resin comprises a polyfunctional epoxy resin. In one embodiment of the present invention, the epoxy resin comprises a polyfunctional epoxy resin and a monofunctional epoxy resin.

A monofunctional epoxy resin is an epoxy resin having one epoxy group. Examples of monofunctional epoxy resins include, but are not limited to, n-butyl glycidyl ether, 2-ethylhexyl glycidyl ether, phenyl glycidyl ether, cresyl glycidyl ether, p-s-butylphenyl glycidyl ether, styrene oxide, α-pinene oxide, 4-tert-butylphenyl glycidyl ether, neodecanoic acid glycidyl ester, 2-(4,4-dimethylpentan-2-yl)-5,7,7-trymethyloctanoic acid glycidyl ester and the like. These resins can be used individually or in combination.

A polyfunctional epoxy resin is an epoxy resin having two or more epoxy groups. The polyfunctional epoxy resins are roughly classified into aliphatic polyfunctional epoxy resins and aromatic polyfunctional epoxy resins. The aliphatic polyfunctional epoxy resin is a polyfunctional epoxy resin having a structure with no aromatic ring. Examples of aliphatic polyfunctional epoxy resins include, but are not limited to:
- diepoxy resins such as (poly)ethylene glycol diglycidyl ether, (poly)propylene glycol diglycidyl ether, butanediol diglycidyl ether, neopentyl glycol diglycidyl ether, 1,6-hexanediol diglycidyl ether, trimethylolpropane diglycidyl ether, polytetramethylene ether glycol diglycidyl ether, glycerin diglycidyl ether, neopentyl glycol diglycidyl ether, 1,2-epoxy-4-(2-methyloxiranyl)-1-methylcyclohexane, cyclohexane-based diglycidyl ethers, and dicyclopentadiene-based diglycidyl ethers;
- triepoxy resins such as trimethylolpropane triglycidyl ether, and glycerin triglycidyl ether;
- tetraepoxy resins such as pentaerythritol tetraglycidyl ether;
- alicyclic epoxy resins such as vinyl (3,4-cyclohexene)dioxide, 2-(3,4-epoxycyclohexyl)-5,1-spiro-(3,4-epoxycyclohexyl)-m-dioxane;
- glycidylamine-based epoxy resins such as tetraglycidyl bis(aminomethyl)cyclohexane;
- hydantoin-based epoxy resins such as 1,3-diglycidyl-5-methyl-5-ethylhydantoin; and
- epoxy resins having a silicone backbone such as 1,3-bis(3-glycidoxypropyl)-1,1,3,3-tetramethyldisiloxane.

These resins can be used individually or in combination.

The aromatic polyfunctional epoxy resin is a polyfunctional epoxy resin having a structure with an aromatic ring. There are many epoxy resins of this type that have conventionally been used frequently, such as bisphenol A-based epoxy resins. Examples of aromatic polyfunctional epoxy resins include, but are not limited to:
- bisphenol A-based epoxy resins;
- branched polyfunctional bisphenol A-based epoxy resins such as p-glycidyloxyphenyldimethyl trisbisphenol A diglycidyl ether;
- bisphenol F-based epoxy resins;
- novolac-based epoxy resins;
- tetrabromobisphenol A-based epoxy resins;
- fluorene-based epoxy resins;
- biphenyl aralkyl epoxy resins;
- diepoxy resins such as 1,4-phenyldimethanol diglycidyl ether;
- triepoxy resins such as tris(4-hydroxyphenyl)methane triglycidyl ether and a reaction product of 4,4'-[1-[4-[1-(4-hydroxyphenyl)-1-methylethyl]phenyl]ethylidene]bisphenol with epichlorohydrin;
- tetraepoxy resins such as 1,1,2,2-tetrakis[4-(glycidyloxy)phenyl]ethane;
- biphenyl-based epoxy resins such as 3,3',5,5'-tetramethyl-4,4'-diglycidyloxybiphenyl;
- glycidylamine-based epoxy resins such as diglycidylaniline, diglycidyltoluidine, triglycidyl-p-aminophenol, tetraglycidyl-m-xylylenediamine; and
- naphthalene ring-containing epoxy resins.

These resins can be used individually or in combination.

The epoxy equivalent weight of the epoxy resin is preferably 80 to 500 g/eq, more preferably 80 to 450 g/eq, still more preferably 80 to 300 g/eq.

Incidentally, a silane coupling agent having a functional group, such as an epoxy group, is not included in the thermosetting resin. It is preferred that the thermosetting resin contains no silicon atom.

### (B) Latent curing agent

The curable resin composition of the present invention comprises a latent curing agent. A latent curing agent means a curing agent for the above-mentioned epoxy resin whose curing action is reversibly blocked so that the curing action can be restored by an appropriate physical or chemical stimulus (such as heat, reaction with water, electromagnetic wave, ultrasound wave and mechanical shear). Therefore, in a mixture obtained by mixing the epoxy resin and latent curing agent, almost no or no progress of the curing reaction occurs at ordinary temperature. However, when an appropriate stimulus is added to this mixture, the restored curing action of the latent curing agent brings progress of the curing reaction.

Conventionally known latent curing agents include those in the form of solid and those in the form of liquid at ordinary temperature (such as 25 °C). It is preferred that the latent curing agent used in the present invention is in the form of solid at 25 °C.

In the present invention, it is preferred that the curing action of the latent curing agent substantially does not appear prior to heating but can be restored by heating. A latent curing agent whose curing action can be restored by heating is hereinafter referred to as a "thermally activated curing agent" for convenience. It is especially preferred that the curing action of the thermally activated curing agent can be restored by heating to the temperature higher than 25 °C. In some embodiment of the present invention, the curing action of the thermally activated curing agent is restored by heating even to the temperature of 40 °C or less. In some embodiment, the latent curing agent is a thermally activated curing agent.

As examples of measures for reversibly blocking the curing action of the thermally activated curing agent so that the curing action can be restored by heating, there can be mentioned modification to a substance having a softening point, microencapsulation (encapsulation into microcapsules) and the like.

In an embodiment, the thermally activated curing agent is a modified amine having a softening point or a microencapsulated latent curing agent.

The modified amine having a softening point used in the present invention is in the form of solid at 25 °C and comprises an amine compound. The amine compound may be selected from, for example, aliphatic primary amines, alicyclic primary amines, aromatic primary amines, aliphatic secondary amines, alicyclic secondary amines, aromatic secondary amines, aliphatic tertiary amines, alicyclic tertiary amines, aromatic tertiary amines, imidazole compounds and imidazoline compounds. It is preferred that the amine compound is selected from aliphatic tertiary amines, alicyclic tertiary amines, aromatic tertiary amines, imidazole compounds and imidazoline compounds. The amine compound may be used in the form of a product of a reaction thereof with a carboxylic acid, sulfonic acid, isocyanate, epoxide or the like. These compounds can be used individually or in combination. For example, the above-mentioned amine compound can be used in combination with a product of a reaction of the amine compound with a carboxylic acid, sulfonic acid, isocyanate or epoxide. In an embodiment, the modified amine having a softening point comprises an imidazole compound and/or a tertiary amine compound.

The modified amine having a softening point is commercially available, but can be prepared by a conventionally known method. As examples of the conventionally known methods, there can be mentioned a method described in JP 2005-206744 and the like. Representative examples of the commercially available modified amine having a softening point include, but not limited to, "Fujicure FXR-1 121", "Fujicure FXR-1020", "Fujicure FXR-1030", "Fujicure FXR-1081", "Fujicure FXR-1032", "Fujicure FXR-1131" and the like.

In an embodiment, the thermally activated curing agent is a microencapsulated latent curing agent. The microencapsulated latent curing agent is a curing agent for the epoxy resin whose curing action is reversibly blocked by microencapsulation. In this microencapsulated latent curing agent, the curing action may optionally be restored by, in addition to heating, another appropriate physical or chemical stimulus (such as mechanical shear).

There is no particular limitation with respect to the curing agent contained in the microencapsulated latent curing agent as long as the curing agent can cure the above-mentioned epoxy resin. As examples of the curing agent contained in the microencapsulated latent curing agent, there can be mentioned an amine compound (including an imidazole compound) and the like.

The microencapsulated latent curing agent preferably comprises an amine compound. The amine compound may be selected from, for example, aliphatic primary amines, alicyclic primary amines, aromatic primary amines, aliphatic secondary amines, alicyclic secondary amines, aromatic secondary amines, aliphatic tertiary amines, alicyclic tertiary amines, aromatic tertiary amines, imidazole compounds and imidazoline compounds. It is preferred that the amine compound is selected from aliphatic tertiary amines, alicyclic tertiary amines, aromatic tertiary amines, imidazole compounds and imidazoline compounds. The amine compound may be used in the form of a product of a reaction thereof with a carboxylic acid, sulfonic acid, isocyanate, epoxide or the like. These compounds can be used individually or in combination. For example, the above-mentioned amine compound can be used in combination with a product of a reaction of the amine compound with a carboxylic acid, sulfonic acid, isocyanate or epoxide.

In an embodiment, the microencapsulated latent curing agent comprises an imidazole compound. As examples of the imidazole compound, there can be mentioned imidazole; 2-subsutituted imidazole compounds, such as 2-methylimidazole, 2-ethylimidazole, 1-isobutyl-2-methylimidazole, 2-ethyl-4-methylimidazole, 2-phenylimidazole, 2-phenyl-4-methylimidazole, 2-phenyl-4-methyl-5-hydroxymethylimidazole, 1-benzyl-2-methylimidazole, 1-benzyl-2-phenylimidazole, 1,2-dimethylimidazol, 1-cyanoethyl-2-methylimidazole, 1-cyanoethyl-2-ethyl-4-methylimidazole, 1-cyanoethyl-2-undecylimidazole and 1-cyanoethyl-2-phenylimidazol; trimellitates, such as 1-cyanoethyl-2-undecylimidazolium trimellitate and 1-cyanoethyl-2-phenylimidazolium trimellitate; triazine ring-containing compounds, such as 2,4-diamino-6-[2-methyl-1-imidazolyl)ethyl]s-triazine, 2,4-diamino-6-[(2-undecyl-1 -imidazolyl)ethyl] s-triazine and 2,4-diamino-6-[(2-ethyl-4-methyl-1-imidazolyl)ethyl]s-triazine; isocyanuric acid adduct of 2,4-diamino-6-[2-methyl-1-imidazolyl)ethyl]s-triazine, isocyanuric acid adduct of 2-phenylimidazole, isocyanuric acid adduct of 2-methylimidazole, isocyanuric acid adduct of 2-phenyl-4,5-dihydroxymethylimidazole, isocyanuric acid adduct of 2-phenyl-4-methyl-5-hydroxymethylimidazole, and the like. As other examples, there can be mentioned adducts of the above-mentioned imidazoles to epoxy resins, and the like.

Among these imidazole compounds, preferred are 2-phenyl-4-methylimidazole, 2,4-diamino-6-[2-methyl-1-imidazolyl)ethyl]s-triazine, 2-phenyl-4-methyl-5-hydroxymethylimidazole (including the isocyanuric acid adducts thereof) and the like.

The microencapsulated latent curing agent used in the present invention is commercially available, but can be prepared by a conventionally known method for microencapsulating a curing agent. As an example of the conventionally known method for microencapsulation, there can be mentioned a method in which coating of an isocyanate compound is formed on the surface of particles of a curing agent in the form of fine powder (WO2004/037885, WO2005/095486). Further, also can be mentioned, for example, a method comprising coating, with a material capable of forming a coating, the surface of particles of a curing agent in the form of fine powder (JP H05-247179, JP H06-73163 and the like). Representative examples of the commercially available microencapsulated latent curing agent include, but not limited to, "Novacure HXA9322HP" (trade name, manufactured by Asahi Kasei Corp.), "Novacure HXA3922HP" (trade name, manufactured by Asahi Kasei Corp.), "Novacure HXA3932HP" (trade name, manufactured by Asahi Kasei Corp.), "Novacure HX3921HP" (trade name, manufactured by Asahi Kasei Corp.), "Novacure HX3941HP" (trade name, manufactured by Asahi Kasei Corp.), "Novacure HXA5945HP" (trade name, manufactured by Asahi Kasei Corp.), "Novacure HXA5911HP" (trade name, manufactured by Asahi Kasei Corp.), "Novacure HXA4921HP" (trade name, manufactured by Asahi Kasei Corp.), "Novacure HXA4922HP" (trade name, manufactured by Asahi Kasei Corp.), "Novacure HX-3742" (trade name, manufactured by Asahi Kasei Corp.), "Novacure HX-3721" (trade name, manufactured by Asahi Kasei Corp.) and the like. Among these, each of the curing agents with a grade accompanied by "HP" is preferred for use in electronic materials because of low chorine content.

The microencapsulated latent curing agent may be provided in the form of a dispersion comprising a liquid epoxy resin having dispersed therein a curing agent (such as a powder consisting of an amine compound) encapsulated in microcapsules. It should be noted that if a curing agent in such a form is used, the amount of this liquid epoxy resin is also included in the amount of the above-mentioned (A) epoxy resin in the curable resin composition of the present invention.

In some embodiment of the present invention, the latent curing agent or thermally activated curing agent comprises an amine compound. Examples of usable amine compounds are substantially the same as those for the above-mentioned microencapsulated latent curing agent.

The curable resin composition of the present invention may contain the latent curing agents individually or in combination. The curable resin composition of the present invention may comprise the latent curing agent in combination with a curing agent in another form, as long as the effect of the present invention is not adversely affected.

In some embodiment, the latent curing agent comprises no phenol compound.

The curable resin composition of the present invention comprises the latent curing agent in an amount of preferably 0.1 to 50 % by weight, more preferably 1 to 30 % by weight, especially preferably 1 to 20 % by weight, based on the total amount of the above-mentioned (A) epoxy resin and (C) phenol-based curing agent.

The fact that the curable resin composition of the present invention comprises the latent curing agent has great significance.

In a curable resin composition comprising a non-latent curing agent, the lowest viscosity during the heating for curing is observed at high temperature. For example, in a curable resin composition comprising an imidazole compound, a crystalline curing agent, the temperature at which the lowest viscosity is observed is typically 75 °C or more. When such a curable resin composition is heated for curing, the composition is in a state of low viscosity for a long period of time until loss of fluidity, and the cured product given by the heating has smooth and glossy surface. In this example, it is presumed that after the dissolution of the imidazole compound in the epoxy resin, the imidazole compound immediately diffused across the epoxy resin forms a salt with the phenol-based curing agent, which brings difficulty in progress of reaction between the epoxy resin molecules or the epoxy resin and phenol-based curing agent so that the temperature at which the lowest viscosity is observed becomes higher.

On the other hand, in the curable resin composition of the present invention comprising the latent curing agent, the temperature at which the lowest viscosity is observed is 70 °C or less, preferably 60 °C or less. In such a resin composition, formation of a salt with the phenol-based curing agent is considered to be difficult, since the curing action of the latent curing agent is not restored immediately after the resin composition is heated for curing. For this reason, it is difficult for the composition to be in a state of low viscosity during period of time until loss of fluidity, and curing of the composition is completed prior to formation of smooth and glossy surface.

### (C) Phenol-based curing agent

The curable resin composition of the present invention comprises a phenol-based curing agent. The phenol-based curing agent is not latent. There is no particular limitation with respect to the phenol-based curing agent as long as the curing agent comprises a phenol compound having a free phenolic hydroxyl group and being capable of curing the above-mentioned (A) epoxy resin.

As the above-mentioned phenol compound, a phenol resin, particularly a novolac resin, which can be obtained by condensation of phenols or naphthols (such as phenol, cresol, naphthol, an alkylphenol, a bisphenol and a terpene phenol) with formaldehyde, is preferably used. As examples of the novolac resin, there can be mentioned a phenol novolac resin, an o-cresol novolac resin, a p-cresol novolac resin, an α-naphthol novolac resin, a β-naphthol novolac resin, a t-butylphenol novolac resin, a bisphenol A-type novolac resin, a xylylene-modified novolac resin, a decalin-modified novolac resin, an allylated phenol novolac resin and the like. As examples of other phenol resins, there can be mentioned a dicyclopentadiene cresol resin, a poly(p-vinylphenol), a poly(di-o-hydroxyphenyl)methane, a poly(di-m-hydroxyphenyl)methane, a poly(di-p-hydroxyphenyl)methane and the like. These phenol compounds can be used individually or in combination. From the viewpoint of workability, it is preferred that the phenol-based curing agent is in the form of liquid at 25 °C. Further, from the viewpoint of suppression of surface gloss of a cured product, it is preferred that the phenol-based curing agent is an allylated phenol novolac resin.

Too much phenol-based curing agent contained in the curable resin composition of the present invention may bring delay in curing. As a result, the period of time in which the composition exhibits fluidity (leveling property) to some extent or more may be extended and the surface gloss of the cured product produced by the curing may not be lowered. For this reason, in the present invention, it is preferred that [the total number of hydroxyl groups for (C) phenol-based curing agent] / [the total number of epoxy groups for (A) epoxy resin] is 0.01 to 0.5.

In the present invention, [the total number of hydroxyl groups for (C) phenol-based curing agent] / [the total number of epoxy groups for (A) epoxy resin] is preferably 0.3 or less, further preferably 0.1 or less.

[The total number of hydroxyl groups for (C) phenol-based curing agent] / [the total number of epoxy groups for (A) epoxy resin] is more preferably 0.01 to 0.3, still more preferably 0.01 to 0.2, particularly preferably 0.01 to 0.1.

The total number of epoxy groups for an epoxy resin is the quotient of the mass (g) of the epoxy resin divided by the epoxy equivalent weight of the epoxy resin (if a plurality of epoxy resins are present, the sum of such quotient for each epoxy resin). Epoxy equivalent weight can be determined by the method described in JIS K7236. If the epoxy equivalent weight cannot be determined using this method, it may be calculated as the quotient of the molecular weight of the epoxy resin under consideration divided by the number of epoxy groups in one molecule of the epoxy resin.

The total number of hydroxyl groups for a phenol-based curing agent is the quotient of the mass (g) of the phenol-based curing agent divided by the hydroxyl equivalent weight of the phenol-based curing agent (if a plurality of phenol-based curing agents are present, the sum of such quotient for each phenol-based curing agent). Hydroxyl equivalent weight can be determined by the method described in JIS K0070. This method of determination is described also in JP 2017-210613, WO2019/189023 and the like. If the hydroxyl equivalent weight cannot be determined using this method, it may be calculated as the quotient of the molecular weight of the phenol-based curing agent under consideration divided by the number of hydroxyl groups in one molecule of the phenol-based curing agent.

### (D) Black colorant

The curable resin composition of the present invention comprises (D) a black colorant. A black colorant means a black colored compound by absorption of light with wavelength of visible light (380 to 780nm). Specific examples include pigments and dyes. When the light transmission rate of the cured product of the curable resin composition sealing a wiring in a camera module made of a metal is high, the light reflected by the wiring, such as gold bump, gold wire and the like, may cause a problem of flare phenomenon or the like. Since the curable resin composition of the present invention comprises a black colorant, unintended influence of light to an image sensor (imaging element) in a camera module is further reduced. There is no particular limitation with respect to the black colorant, and a black pigment, such as a black organic pigment, a mixed color organic pigment and an inorganic black pigment (such as carbon black and titanium black), a black organic dye and the like can be used.

Examples of the black organic pigment include perylene black and the like, and examples of the black organic dye include aniline black and the like. Examples of the mixed color organic pigment include a pigment obtained by mixing at least two kinds of pigments selected from red, blue, green, purple, yellow, magenta, cyan and the like to obtain a pseudo-black color. Examples of the inorganic black pigment include fine particles of graphite, metals and oxides (including complex oxides), sulfides, nitrides and the like of the metals. As examples of the metals, there can be mentioned titanium, copper, iron, manganese, cobalt, chromium, nickel, zinc, calcium, silver and the like. In the curable resin composition of the present invention, the black pigments can be used individually or in combination. Further, the black pigment may be used in combination with another colorant, such as a dye.

In the present invention, from the viewpoint of hiding properties, it is preferred that the black colorant comprises a black pigment. The black pigment comprises preferably an inorganic black pigment, more preferably carbon black and/or titanium black. In some embodiment, from the viewpoint of maintenance of insulating property of the cured product, it is preferred that the black colorant is a dye.

The average particle size of primary particles of the black pigment is preferably 20 to 200 nm, more preferably 50 to 150 nm. In the present invention, unless otherwise specified, the average particle size of primary particles of the black pigment refers to the volume-based median diameter (d₅₀) measured by laser diffractometry in accordance with ISO 13320:2009. When the measurement by laser diffractometry is difficult (for example, when the object to be measured comprises fine particles which are difficult to apply laser diffractometry), the average particle size of primary particles of the object to be measured may be measured by another method of measurement. As examples of other methods of measurement, there can be mentioned measurement by observation by a scanning electron microscope (SEM), dynamic light scattering, calculation from specific surface area, and the like. In the present invention, it is preferred that in such a case, the average particle size of primary particles of the object to be measured is calculated from the measurement by SEM observation. It is preferred that the amount of the black colorant is 0.01 to 10 % by mass, based on the total amount of the curable resin composition. When the black colorant is carbon black, the amount is preferably 0.01 to 5 % by mass, more preferably 0.05 to 4 % by mass, based on the total amount of the curable resin composition. When the black colorant is titanium black, the amount is preferably 0.1 to 10 % by mass, more preferably 0.1 to 8 % by mass, based on the total amount of the curable resin composition.

### (E) Filler

The curable resin composition of the present invention comprises a filler. By the fact that the curable resin composition of the present invention comprises a filler, surface gloss of a cured product is further suppressed and, as a result, flare is effectively prevented. Surface gloss of a cured product is suppressed because the filler gives irregular structure on the surface of the cured product and specular reflection is further lowered when the cured product is irradiated with light.

There is no particular limitation with respect to the filler, and various conventionally known fillers can be used. As specific examples of fillers, there can be mentioned inorganic fillers, such as a silica filler, an alumina filler, a talc filler and a calcium carbonate filler; organic fillers, such as a polytetrafluoroethylene (PTFE) filler, an acryl polymer filler and a silicone filler; and the like. In some embodiment of the present invention, the filler comprises a silica filler or a silicone filler, preferably a silica filler.

Further, the filler may be surface-treated with a surface-treating agent, for example a coupling agent such as a silane coupling agent (which may have a substituent, such as a phenyl group, vinyl group, acryloyl group, methacryloyl group and the like). In some embodiment of the present invention, from the viewpoint of easy maintenance of fluidity even under highly filled filler, it is preferred that at least a portion of the filler is surface-treated. In another embodiment, in order for the lowest viscosity of the curable resin composition under heating to become too low, it is preferred that the filler is not surface-treated.

There is no particular limitation with respect to the particle size distribution, average particle size or the like of the filler, but it is preferred that the filler with an average particle size of 20.0 µm or less is used. The average particle size of the filler is preferably 15.0 µm or less, more preferably 10.0 µm or less. If the average particle size is more than 20.0 µm, injection into narrow gap may become difficult. There is no particular limitation with respect to the lower limit of the average particle size. Use of fine filler with an average particle size of approximately 0.005 to 0.05 µm is preferred, since the lowest viscosity under heating does not become too low. In some embodiment, the average particle size of the filler used in the present invention is preferably 0.005 µm or greater and 10.0 µm or less, more preferably 0.005 µm or greater and 5.0 µm or less, still more preferably 0.005 µm or greater and 3.0 µm or less. As used herein, the average particle size of the filler, unless otherwise specified, refers to the volume-based median diameter (d₅₀) measured by laser diffractometry in accordance with ISO 13320:2009.

In view of discharging properties by a dispenser, it is preferred that particles of the filler used in the present invention are spherical.

In the curable resin composition of the present invention, the amount of (E) filler is 20 to 60 % by volume, based on the total amount of the curable resin composition. When the filler comprises 2 or more types of fillers, the amount of the filler is the total amount of all of the fillers.

When the amount of the filler is less than 20 % by volume, based on the total amount of the curable resin composition, the surface of the cured product tends to become glossy because of high relative amount of resin components. The amount of the filler is preferably 25 % or more by volume, more preferably 30 % or more by volume, particularly preferably 35 % or more by volume, based on the total amount of the curable resin composition. On the other hand, when the amount of the filler is more than 60 % by volume, low relative amount of resin components brings concern over deterioration of fluidity of the curable resin composition and/or deterioration of mechanical properties of the cured product. The amount of the filler is preferably 57 % or less by volume, more preferably 55 % or less by volume, based on the total amount of the curable resin composition.

In some embodiment, the amount of the filler is preferably 25 to 60 % by volume, more preferably 25 to 57 % by volume, particularly preferably 25 to 55 % by volume, based on the total amount of the curable resin composition.

The ratio (% by volume) of the volume of the filler relative to the total volume of the curable resin composition can be determined by subjecting, to appropriate image processing by an appropriate graphics software, including binarization treatment and the like, an image data of a cross section of the cured product of the curable resin composition obtained at 3000-fold magnification, for example. The image data can be obtained using, for example, a scanning electron microscope (SEM). This volume ratio (% by volume) may be determined also by calculation from the mass and/or specific gravity of the entire curable resin composition and filler.

Use of a black colorant and/or filler for suppression of flare during imaging by a camera is disclosed in Patent Document 3, for example. However, the invention of Patent Document 3 is related not to a curable resin composition or sealing material but to an antireflection layer or a film for antireflection, which is formed or pasted, respectively, on a flexible printed-circuit board in the interior of a camera, in order to suppress the reflection of light by the circuit board.

The curable resin composition of the present invention may contain optional components other than the above-mentioned (A) to (E), such as those mentioned below, if desired.

### • Stabilizer

The curable resin composition of the present invention may, if desired, comprise a stabilizer. A stabilizer may be added to the curable resin composition of the present invention to improve its storage stability and to prolong its pot life. Various stabilizers known in the art as stabilizers for one-part adhesives may be used, and at least one member selected from the group consisting of a borate ester compound, an aluminum chelate and an organic acid is preferable, and at least one member selected from the group consisting of a liquid borate ester compound and an aluminum chelate is more preferable, because of their high effectiveness in improving storage stability.

As examples of borate ester compounds, there can be mentioned 2,2'-oxybis(5,5'-dimethyl-1,3,2-oxaborinane), trimethyl borate, triethyl borate, tri-n-propyl borate, triisopropyl borate, tri-n-butyl borate, tripentyl borate, triallyl borate, trihexyl borate, tricyclohexyl borate, trioctyl borate, trinonyl borate, tridecyl borate, tridodecyl borate, trihexadecyl borate, trioctadecyl borate, tris(2-ethylhexyloxy)borane, bis(1,4,7,10-tetraoxaundecyl)(1,4,7,10,13-pentaoxatetradecyl)(1,4,7-trioxaundecyl)borane, tribenzyl borate, triphenyl borate, tri-o-tolyl borate, tri-m-tolyl borate, triethanolamine borate and the like. A liquid borate ester compound is preferable, because it is liquid at room temperature (25 °C) and therefore allows the viscosity of a mixture comprising it to be kept low. As an example of the aluminum chelate that may be used, there can be mentioned aluminum chelate A (manufactured by Kawaken Fine Chemical Co., Ltd.). As an example of the organic acid that may be used, there can be mentioned barbituric acid.

When the curable resin composition of the present invention comprises a stabilizer, the amount of the stabilizer is preferably 0.01 to 20 parts by mass, more preferably 0.05 to 10 parts by mass, still more preferably 0.1 to 5 parts by mass, with respect to 100 parts by mass of the total amount of components (A) to (C).

### • Coupling agent

The curable resin composition of the present invention may, if desired, comprise a coupling agent. Addition of a coupling agent, in particular a silane coupling agent, is preferred from the perspective of improving adhesive strength. A silane coupling agent is an organosilicon compound having, in its molecule, two or more different functional groups including a functional group capable of being chemically bonded to an inorganic material and a functional group capable of being chemically bonded to an organic material. Generally, the functional group capable of being chemically bonded to an inorganic material is a hydrolysable silyl group, and a silyl group containing an alkoxy group, especially a methoxy group and/or an ethoxy group, is used as this functional group. As the functional group capable of being chemically bonded to an organic material, a vinyl group, an epoxy group, a (meth)acryl group, a styryl group, an unsubstituted or substituted amino group, a mercapto group, a ureido group, an isocyanate group or the like is used. As the coupling agent, various silane coupling agents having the above-mentioned functional group may be used. As specific examples of the silane coupling agent, there can be mentioned 3-glycidoxypropyltrimethoxysilane, 3-aminopropyltrimethoxysilane, vinyltrimethoxysilane, 3-triethoxysilyl-N-(1,3-dimethyl-butylidene)propylamine, 2-(3,4-epoxycyclohexyl)ethyltrimethoxysilane, p-styryltrimethoxysilane, 3-methacryloxypropylmethyltrimethoxysilane, 3-acryloxypropyltrimethoxysilane, 8-glycidoxyoctyltrimethoxysilane, 3-ureidopropyltriethoxysilane, 3-mercaptopropyltrimethoxysilane, bis(triethoxysilylpropyl)tetrasulfide, 3-isocyanatopropyltriethoxysilane and the like. These silane coupling agents may be used individually or in combination.

In the curable resin composition of the present invention, from the perspective of improving adhesive strength, the amount of the coupling agent is preferably 0.1 to 10 parts by mass, more preferably from 0.3 to 5 parts by mass, with respect to 100 parts by mass of the total amount of components (A) to (C).

### • Other additives

The curable resin composition of the present invention may, if desired, comprise other additives, such as an ion trapping agent, a leveling agent, an antioxidant, an antifoaming agent, a flame retardant, a solvent and the like, insofar as they do not depart from the spirit of the present invention. The type and addition amount of each additive are in accordance with usual practice in the art. However, it is preferred that the curable resin composition of the present invention comprises no thiol compound. This is because a thiol compound may cause corrosion of metal when the curable resin composition of the present invention is used for sealing of a wiring. In an embodiment of the present invention, the curable resin composition comprises substantially no thiol compound.

There is no particular limitation with respect to the method for producing the curable resin composition of the present invention. For example, the curable resin composition of the present invention may be obtained by introducing components (A) to (E) and, if desired, other additives into a suitable mixer simultaneously or separately, followed by stirring and mixing while, if necessary, heating and melting, to yield a homogeneous composition. There is no particular limitation with respect to the mixer, and a Raikai mixer (grinder) equipped with a stirrer and a heater, a Henschel mixer, a three-roll mill, a ball mill, a planetary mixer, a bead mill or the like can be used. These devices may be used in combination, as appropriate.

As described above, the curable resin composition thus obtained can be converted to a final cured product by subjecting it to a thermal curing treatment.

Thermal curing treatment can be performed by heating the curable resin composition of the present invention under appropriate conditions. This heating is preferably performed at 80 to 250 °C, more preferably at 90 to 180 °C, and especially preferably at 90 to 150 °C. This heating is preferably performed for 1 seconds to 120 minutes, more preferably for 10 seconds to 90 minutes, and especially preferably for 15 seconds to 70 minutes.

When the curable resin composition of the present invention is subjected to the above-mentioned thermal curing treatment, the composition gives a cured product with lowered surface gloss. This lowered gloss is brought by the presence of the structure with minute bumps on the surface of the cured product. Due to this structure, the reflection by the surface irradiated with light is mainly diffuse reflection and specular reflection is lowered. This structure with minute bumps is formed by reflection of the shape of (E) filler contained in the composition on the surface of the cured product.

In general, when a curable resin composition is subjected to thermal curing treatment, its viscosity is decreased with increase in temperature so that its fluidity (leveling property) is increased. When the curable resin composition prior to curing is kept in such a state for a certain period of time or more, because of its fluidity, curing occurs concurrently with formation of smooth layer of resin on the surface of the curable resin composition. As a result, the surface of the cured product becomes smooth, and it disadvantageously becomes difficult to lower surface gloss of the cured product.

On the other hand, in the curable resin composition of the present invention, the viscosity is not much decreased and the fluidity (leveling property) is not much increased, even under heating for curing. In an embodiment, in the curable resin composition of the present invention, when determination of dynamic viscoelasticity is carried out in accordance with the provisions of JIS K7244-10 under the conditions of the rate of temperature increase of 3 °C/minute, the temperature range of 25 °C to 120 °C, the frequency of 1000 Hz, the distance of 0.500 mm between the parallel circular plates and the amount of strain of 0.5, the minimum value of the absolute value of the complex shear viscosity within the above-mentioned temperature range is 1.5 Pa• s or more. As used herein, the absolute value of the complex shear viscosity may be simply referred to as the "complex shear viscosity". Further, the minimum value of such a complex shear viscosity observed in the determination of dynamic viscoelasticity may be referred to as the "lowest viscosity".

In addition, in this composition, the curing reaction accompanied with increase in viscosity begins at relatively low temperature. This is suggested by the fact that in the determination of dynamic viscoelasticity of this composition, the lowest complex shear viscosity is observed at relatively low temperature. As a result, this composition exhibits fluidity (leveling property) to some extent or more during only limited period of time, the curing is completed prior to formation of smooth layer of resin on the surface of the curable resin composition and a cured product with lowered surface gloss is produced. In an embodiment, in the curable resin composition of the present invention, when determination of dynamic viscoelasticity is carried out in accordance with the provisions of JIS K7244-10 under the conditions of the rate of temperature increase of 3 °C/minute, the temperature range of 25 °C to 120 °C, the frequency of 1000 Hz, the distance of 0.500 mm between the parallel circular plates and the amount of strain of 0.5, the temperature at which the lowest complex shear viscosity is observed is 55 °C or less.

Therefore, in an assembly with its parts adhered using the curable resin composition of the present invention, a problem caused by specular reflection of light is solved. For example, in a camera module produced using the curable resin composition of the present invention, flare during imaging is drastically suppressed.

In this connection, it is preferred that the curable resin composition of the present invention exhibits large thixotropic properties to some extent. This is because when the composition is heated for curing, the convection caused by the heating is suppressed and the state of the filler dispersed in the composition is maintained. As described above, large thixotropic properties of the composition brings difficulty in sedimentation of the dispersed filler since the state of the filler dispersed in the composition is maintained even under heating. The filler kept dispersed in the composition with no sedimentation makes the shape of the filler more readily reflected on the surface of the cured product and surface gloss of the cured product more readily lowered.

In the curable resin composition of the present invention, the thixotropic index is preferably 1.0 to 5.5, more preferably 1.1 to 5.5, still more preferably 1.2 to 5.0. The thixotropic index is calculated as a value 1 rpm/10 rpm, wherein the values 1 rpm and 10 rpm are the viscosities obtained by subjecting, at 1 rpm and 10 rpm, respectively, the curable resin composition to measurement using an E-type viscometer (TVE-25H: manufactured by Toki Sangyo Co., Ltd., rotor name: 3° x R9.7) under the environment of 25 °C ± 2 °C and 50 % RH ± 10 % RH with an appropriate preset range (H, R, or U).

Further, the curable resin composition of the present invention can ensure certain extent of viscosity or more even at ordinary temperature, because of its specific construction. This is because certain extent of viscosity or more of the composition at ordinary temperature brings difficulty in decrease in the lowest viscosity under heating. In the epoxy resin composition of the present invention, the viscosity at 25 °C is not too low, typically 5 Pa·s or more. In the epoxy resin composition of the present invention, the viscosity at 25 °C is preferably 3 Pa•s or more, more preferably 5 Pa•s or more, still more preferably 8 Pa•s or more. From the viewpoint of injectability, it is preferred that the viscosity at 25 °C is 100 Pa•s or less. As used herein, unless otherwise specified, the viscosity is described as a value measured in accordance with the provisions of Japan Industrial Standard JIS K6833. Specifically, the viscosity can be obtained by measurement at the rate of rotation of 10 rpm using an E-type viscometer. There is no particular limitation with respect to the instrument and/or rotor to be used and/or the range of measurement.

In the present invention, gloss of the surface of an object can be evaluated by the specular glossiness measured at an incident angle of 20 degrees in accordance with the provisions of JIS Z 8741. This specular glossiness of the cured product given by the curable resin composition of the present invention is preferably 10 % or less, more preferably 5 % or less, when the film thickness of the cured product is 100 µm or more.

The curable resin composition of the present invention can be used as an adhesive or a sealing material. Further, the curable resin composition of the present invention can be used for producing camera modules. More specifically, the curable resin composition of the present invention can be used for the adhesion and sealing of components for camera modules, especially for sealing a wiring connecting an image sensor and a substrate in a camera module.

In the present invention, also provided is a sealing material comprising the curable resin composition of the present invention. For example, the sealing material of the present invention is suitable for sealing a wiring connecting an image sensor and a substrate in a camera module.

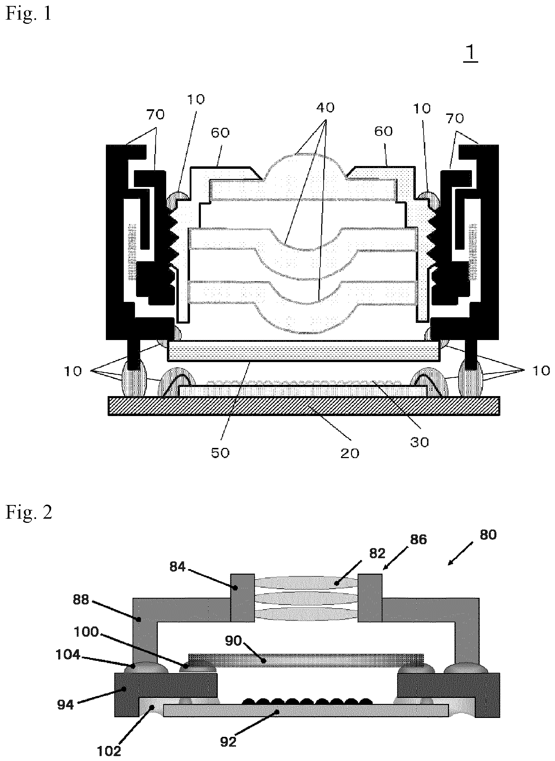

In some embodiment, an image sensor is connected to a substrate by wire bonding method. In this case, the wiring connecting an image sensor and a substrate is a bonding wire. An example of a cross-section of a camera module in which an image sensor is connected to a substrate by wire bonding method is given in Figure 1. In this figure, the wiring (bonding wire) connecting an image sensor and a substrate is sealed with cured product of adhesive 10. The adhesive may be a sealing material.

In another embodiment, an image sensor is connected to a substrate by flip-chip bonding method. An example of a cross-section of a camera module in which an image sensor is connected to a substrate by flip-chip bonding method is given in Figure 2. In this figure, the wiring (bump) connecting an image sensor and a substrate is sealed with cured product of adhesive 102. The adhesive may be a sealing material.

In an embodiment of the present invention, the curable resin composition or sealing material of the present invention is for preventing flare during imaging. In an embodiment of the present invention, also provided is the curable resin composition or sealing material of the present invention for giving a cured product having, on the surface thereof, a structure with minute bumps.

The curable resin composition of the present invention can be used, for example, as an adhesive for adhering a semiconductor device (especially that in which suppression of reflection of light inside that is important) comprising various electronic components and parts constituting an electronic component, or as a raw material thereof.

In the present invention, also provided is a cured product obtained by curing the curable resin composition or sealing material of the present invention. Further, in the present invention, also provided is a camera module comprising the cured product of the present invention.

### EXAMPLES

Hereinafter, the present invention will be described by way of examples, but the present invention is not limited thereto. In the following examples, parts and percentages, unless otherwise specified, represent parts by mass and percentages by mass.

### Examples 1 to 6 and Comparative Examples 1 to 6

Curable resin compositions were prepared by mixing each of the components in the amounts according to the formulations shown in Table 1 using a three-roll mill. In Table 1, the amount of each component is expressed in parts by mass (unit: g).

### (A) Epoxy resin

The compounds used as (A) epoxy resin in Examples and Comparative Examples are as follows.
(A-1) Naphthalene-based epoxy resin (trade name: HP-4032D, manufactured by DIC Corporation, epoxy equivalent weight: 130)
(A-2) bisphenol F-based epoxy resin (average molecular weight: 318) (trade name: YDF-8170, manufactured by Nippon Steel Chemical & Material Co., Ltd., epoxy equivalent weight: 159)
(A-3) bisphenol F-based epoxy resin / bisphenol A-based epoxy resin mixture (trade name: EXA-835LV, manufactured by DIC Corporation, epoxy equivalent weight: 165)
(A-4) 1,4-cyclohexanedimethanol diglycidyl ether (trade name: CDMDG, manufactured by Showa Denko K.K., epoxy equivalent weight: 136)
(A-5) p-tert-butylphenylglycidyl ether (trade name: ED509S, manufactured by ADEKA Corporation, epoxy equivalent weight: 205)

### (B) Latent curing agent

The compounds used as (B) latent curing agent in Examples and Comparative Examples are as follows.
(B-1) Latent curing agent 1 (trade name: Novacure HXA3932HP, manufactured by Asahi Kasei Corp.)
(B-2) Latent curing agent 2 (trade name: Novacure HXA9322HP, manufactured by Asahi Kasei Corp.)
(B-3) Latent curing agent 3 (trade name: Novacure HXA5945HP, manufactured by Asahi Kasei Corp.)

Each of the above-mentioned (B-1) to (B-3) is provided in the form of a dispersion (latent curing catalyst / mixture of bisphenol A-based epoxy resin and bisphenol F-based epoxy resin = 33/67 (mass ratio)) in which the microencapsulated latent curing catalyst in particulate form is dispersed in an epoxy resin (mixture of a bisphenol A-based epoxy resin and a bisphenol F-based epoxy resin (epoxy equivalent weight: 170)). The epoxy resins constituting this dispersion are treated as forming part of (A). Therefore, in Table 1, the amount of only the latent curing catalyst in each of (B-1) to (B-3) is shown in the row for (B), and the amount of the epoxy resin in each of (B-1) to (B-3) is shown in the row for (A).

### (C) Phenol-based curing agent

The compound used as (C) phenol-based curing agent in Examples and Comparative Examples is as follows.
(C-1) Liquid phenol novolak resin (trade name: MEH-8005, manufactured by Meiwa Plastic Industries, Ltd., hydroxyl equivalent weight: 136)

### (C') Curing agent other than the above-mentioned (B) or (C)

The compounds used as a curing agent other than the above-mentioned (B) or (C) in Examples and Comparative Examples are as follows.
(C'-1) Imidazole compound (trade name: CUREZOL 2E4MZ, manufactured by Shikoku Chemicals Corporation)
(C'-2) Acid anhydride (trade name: jERCURE YH306, manufactured by Mitsubishi Chemical Corporation)

### (D) Black colorant

The compound used as (D) black colorant in Examples and Comparative Examples is as follows.
(D-1) Carbon black (trade name: Special Black 4, manufactured by Orion Engineered Carbons S.A.)

### (E) Filler

The compounds used as (E) filler in Examples and Comparative Examples are as follows.
(E-1) Silica filler 1 (trade name: SO-E5, average particle size: 2.0 µm, manufactured by Admatechs Co., Ltd.)
(E-2) Silica filler 2 (trade name: SE2300, average particle size: 0.6 µm, manufactured by Admatechs Co., Ltd.)
(E-3) Silica filler 3 (trade name: SEAHOSTAR (registered trademark) KE-S30HG, average particle size: 0.3 µm, manufactured by Nippon Shokubai Co., Ltd.)
(E-4) Silicone hybrid powder filler (trade name: KMP-600, average particle size: 5 µm, manufactured by Shin-Etsu Chemical Co., Ltd.)
(E-5) Surface-treated silica filler (trade name: Aerosil (registered trademark) R805, manufactured by Nippon Aerosil Co., Ltd., average particle size: 12 nm, surface-treated with octylsilane)

### (Amount of (E) filler (% by volume))

Based on the understanding that the specific gravity of each of (A), (B), (C) and (C'-1) is 1.1 g/cm³, the specific gravity of (C'-2) is 1.2 g/cm³, the specific gravity of (D) is 1.9 g/cm³, the specific gravity of each of (E-1) to (E-3) and (E-5) is 2.2 g/cm³ and the specific gravity of (E-4) is 0.99 g/cm³, the ratio (% by volume) of the volume of (E) filler relative to the total volume of the curable resin composition was determined from the mass of each component. Results are given in Table 1 as "Amount of (E) filler (% by volume)".

### (Dynamic viscoelasticity (lowest viscosity under heating and temperature for this viscosity))

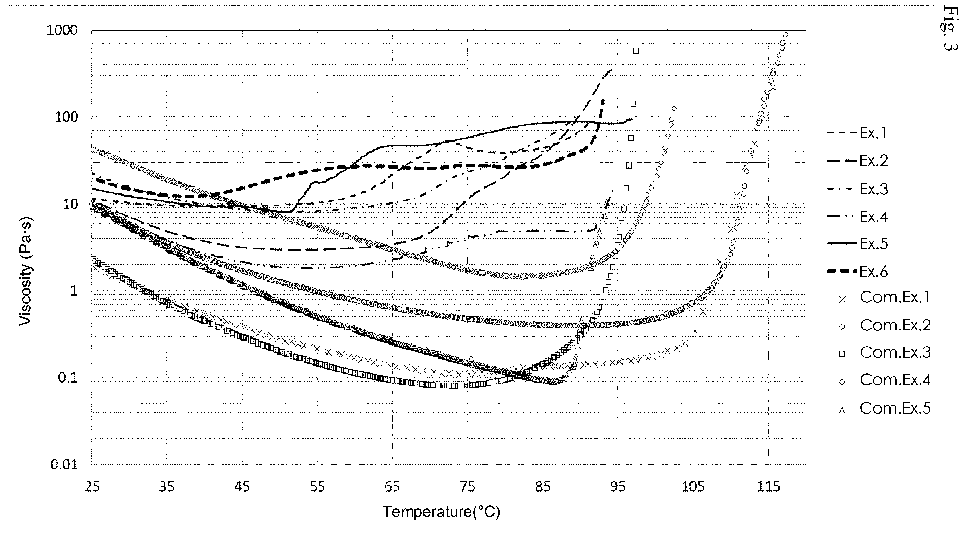

The complex shear viscosity (Pa·s) of the curable resin composition was determined using a rheometer (MARS II, manufactured by HAAKE) in accordance with the provisions of JIS K7244-10 under the conditions of the frequency of 1000 Hz, the distance of 0.500 mm between the parallel circular plates and the amount of strain of 0.5, while the temperature was increased from room temperature (25 °C) to 120 °C at the rate of temperature increase of 3 °C/minute. With respect to each of the curable resin compositions, the temperature within the above-mentioned temperature range at which the lowest complex shear viscosity was observed and the complex shear viscosity observed at this temperature (lowest viscosity) are given in Table 1. Further, the change in complex shear viscosity against the temperature during this determination of dynamic viscoelasticity with respect to the curable resin composition of each of Examples 1 to 6 and Comparative Examples 1 to 5 is given in Figure 3.

### (Viscosity at 25 °C)

The viscosity (unit: Pa·s) of the curable resin composition was meas(Viscosity at 25 °C)ured using an E-type rotational viscometer manufactured by Brookfield Engineering Laboratories, Inc. (TVE-25H: manufactured by Toki Sangyo Co., Ltd., rotor name: 3° x R9.7) under the conditions of 25 °C and 10 rpm. Results are shown in Table 1.

### (Thixotropic index (TI))

The viscosity (unit: Pa·s) of the curable resin composition was measured under the conditions substantially the same as those for "Viscosity at 25 °C" described above, except that the rate of rotation was 1 rpm. By this viscosity, "Viscosity at 25 °C" described above was divided. The thixotropic index (TI) of the curable resin composition was calculated as a value thus obtained. Results are shown in Table 1.

### (Evaluation of specular glossiness of the surface of cured product)

A curable resin composition applied on an SUS plate of 40 mm * 60 mm * 3 mm was heated at 120 °C for 1 hour using a fine oven DH412 manufactured by Yamato Scientific Co., Ltd. so that a cured product with a thickness of 300 ± 20 µm was formed on the SUS plate. The resultant cured product on the SUS plate was used as a test piece.

Specular glossiness (%) of the surface of this test piece was measured using Gloss Checker IG-331 manufactured by HORIBA, Ltd. (light source: LED (wavelength 890 nm)) in accordance with the provisions of JIS Z 8741 under the conditions of an incident angle of 20 degrees and an acceptance angle of 20 degrees. The results are shown in Table 1.

### (Evaluation of specular glossiness of the surface of thin film of cured product)

Substantially the same procedure as in "Evaluation of specular glossiness of the surface of cured product" described above was repeated, except that the thickness of the cured product on the SUS plate was 50 ± 10 µm. When the specular glossiness could not be measured due to too high intensity of the reflected light, the result was shown as "OR". The results are shown in Table 1.

### [Table 1]

**Table 1**

| | | Ex.1 | Ex.2 | Ex.3 | Ex.4 | Ex.5 | Ex.6 | Com.Ex.1 | Com.Ex.2 | Com.Ex.3 | Com.Ex.4 | Com.Ex.5 | Com.Ex.6 |
|---|---|---|---|---|---|---|---|---|---|---|---|---|---|
| (A) | (A - 1) | | | 7.2 | | | | | | | | | |
| | (A - 2) | 9.4 | 26.4 | 7.2 | 30.5 | 28.5 | | 9.5 | 14.0 | | | | 26.0 |
| | (A - 3) | | | | | | 38.0 | | | 89.5 | 38.0 | 34.5 | |
| | (A - 4) | 18.0 | | 2.5 | 2.4 | 2.2 | | 3.9 | | | | | |
| | (A - 5) | | | | | 19.5 | | | | | | | |
| | (B - 1) | 16.1 | | | 7.4 | | | 3.0 | | | | 40.2 | |
| | (B - 2) | | 17.4 | 9.4 | | | | | | | | | 16.8 |
| | (B - 3) | | | | | 14.4 | | | | | | | |
| (B) | (B - 1) | 7.9 | | | 3.6 | | | 1.5 | | | | 19.8 | |
| | (B - 2) | | 8.6 | 4.6 | | | | | | | | | 8.3 |
| | (B - 3) | | | | | 7.1 | | | | | | | |
| | (B - 4) | | | | | | 3.3 | | | | | | |
| (C) | (C - 1) | 2.5 | 2.5 | 2.0 | 3.0 | 3.0 | 1.5 | | | | 1.5 | 5.4 | 3.0 |
| (C') | (C' - 1) | | | | | | | | 2.0 | 10.3 | 3.3 | | |
| | (C' - 2) | | | | | | | 17.0 | 17.0 | | | | |
| (D) | (D - 1) | 0.05 | 0.05 | 0.05 | 0.10 | 0.20 | 0.20 | 0.10 | 0.20 | 0.20 | 0.20 | 0.10 | 0.00 |
| (E) | (E - 1) | | | 65.0 | 53.0 | | 55.5 | 65.0 | 48.8 | | 55.5 | | |
| | (E - 2) | 42.5 | | | | | | | | | | | |
| | (E - 3) | | 43.0 | | | | | | 15.0 | | | | 44.0 |
| | (E - 4) | | | | | 21.0 | | | | | | | |
| | (E - 5) | 3.6 | 2.1 | 2.1 | 0.0 | 4.1 | 1.5 | 0.0 | 3.0 | 0.0 | 1.5 | 0.0 | 2.0 |
| Total | | 100 | 100 | 100 | 100 | 100 | 100 | 100 | 100 | 100 | 100 | 100 | 100 |
| Amount of (E) filler (volume %) | | 30 | 29 | 50 | 36 | 25 | 40 | 49 | 51 | 0 | 40 | 0 | 30 |
| (C)/(A)^{a} | | 0.06 | 0.07 | 0.08 | 0.09 | 0.06 | 0.05 | 0.00 | 0.00 | 0.00 | 0.05 | 0.09 | 0.08 |
| viscosity (Pa·s, 25 °C) | | 15 | 21 | 55 | 22 | 12 | 35 | 5 | 70 | 3 | 80 | 15 | 19 |
| Thixotropic index | | 3.0 | 1.4 | 2.2 | 1.1 | 5.1 | 2.0 | 1 | 0.9 | 0.9 | 2.2 | 1 | 1.4 |
| Lowest viscosity (Pa·s)^{b} | | 9.43 | 2.96 | 8.18 | 1.84 | 7.98 | 12.24 | 0.11 | 0.40 | 0.08 | 1.46 | 0.09 | 2.70 |
| Temperature (°C) at which the lowest viscosity was observed^{c} | | 45 | 53 | 52 | 55 | 51 | 38 | 75 | 86 | 74 | 82 | 86 | 53 |
| Specular glossiness of the surface of cured product | | 0 | 0 | 1 | 1 | 0 | 0 | 32 | 20 | 89 | 87 | 35 | |
| Specular glossiness of the surface of thin film of cured product | | | 1 | | | | | | | | | | OR |

| | | | | | | | | | | | | | |
|---|---|---|---|---|---|---|---|---|---|---|---|---|---|
| a: [total number of hydroxyl groups for (C) phenol-based curing agent] I [total number of epoxy groups for (A) epoxy resin] b: Minimum value of the absolute value of the complex shear viscosity observed in the measurement of dynamic viscoelasticity c: Temperature at which the minimum value of the absolute value of the complex shear viscosity was observed in the measurement of dynamic viscoelasticity | | | | | | | | | | | | | |

### (Discussion of Results)

The curbale resin composition of the present invention, which comprises a latent curing agent in combination with a phenol-based curing agent as well as a black colorant and a specific amount of a filler, gives a cured product with extremely lowered surface gloss (Examples 1 to 6). This is because this composition exhibits fluidity (leveling property) to some extent or more during only limited period of time even under the heating for curing, and the curing is completed prior to formation of smooth layer of resin on the surface of the composition.

On the other hand, a curable resin composition comprising no filler or comprising a curing agent other than that in the above-mentioned combination gives a cured product in which surface gloss is not lowered (Comparative Examples 1 to 5). This is because the period of time during which this composition under the heating for curing exhibits leveling property is sufficiently long for formation of smooth layer of resin on the surface of the composition prior to curing.

A curable resin composition comprising no black colorant gives a cured product with high light transmission rate. When this cured product is in the form of a thin film formed on a metal plate, measurement of the specular glossiness of the surface of the cured product becomes difficult because of light reflected by the metal plate and passing through the cured product (Comparative Example 6). When a wiring in a semiconductor device made of a metal is sealed with such a composition, the light reflected by the wiring may cause a problem of flare phenomenon or the like.

### INDUSTRIAL APPLICABILITY

The curable resin composition of the present invention comprises a latent curing agent in combination with a phenol-based curing agent as curing agents for curing an epoxy resin, as well as a black colorant and a specific amount of a filler. Therefore, the curable resin composition of the present invention gives a cured product with lowered surface gloss. Such a curable resin composition is extremely useful in the production of various semiconductor devices for use in which reflection of light on the surface of the cured product given by the composition may be a problem, especially a camera module.

The disclosure of Japanese Patent Application No. 2021-188312 (filed on November 19, 2021) is incorporated herein by reference in its entirety.

All publications, patent applications, and technical standards mentioned in the present specification are incorporated herein by reference to the same extent as if such individual publication, patent application, or technical standard was specifically and individually indicated to be incorporated by reference.

### REFERENCE SIGNS LIST

- 1: Camera module with an image sensor mounted by wire bonding
- 10: Cured product of adhesive
- 20: Substrate
- 30: Image sensor
- 40: Optical lens
- 50: Optical filter
- 60: Lens barrel
- 70: VCM (Voice Coil Motor)
- 80: Camera module with an image sensor mounted by flip-chip mounting
- 82: Lens
- 84: Voice coil motor
- 86: Lens unit
- 88: Support
- 90: Cutting filter
- 92: Imaging element
- 94: Printed circuit board
- 100, 102, 104: Cured product of adhesive

## Claims

1. A curable resin composition comprising:
(A) an epoxy resin,
(B) a latent curing agent,
(C) a phenol-based curing agent,
(D) a black colorant, and
(E) a filler,
wherein the amount of (E) filler is 20 to 60 % by volume, based on the total amount of the curable resin composition.

2. The curable resin composition according to claim 1, which comprises substantially no thiol compound.

3. The curable resin composition according to claim 1 or 2, wherein [the total number of hydroxyl groups for (C) phenol-based curing agent] / [the total number of epoxy groups for (A) epoxy resin] is 0.1 or less.

4. The curable resin composition according to any one of claims 1 to 3, wherein (B) latent curing agent comprises an imidazole compound and/or a tertiary amine compound.

5. The curable resin composition according to any one of claims 1 to 4, wherein (B) latent curing agent is a microencapsulated latent curing agent.

6. The curable resin composition according to any one of claims 1 to 5, wherein the amount of (E) filler is 35 % by volume or more, based on the total amount of the curable resin composition.

7. The curable resin composition according to any one of claims 1 to 6, wherein the lowest viscosity determined by dynamic mechanical analysis under the conditions of the rate of temperature increase of 3 °C/minute and the temperature range of 25 °C to 120 °C is 1.5 Pa·s or more.

8. A sealing material comprising the curable resin composition of any one of claims 1 to 7.

9. The sealing material according to claim 8 for sealing a wiring connecting an image sensor and a substrate in a camera module.

10. The sealing material according to claim 8 or 9 for preventing flare.

11. A cured product of the curable resin composition of any one of claims 1 to 7 or the sealing material of any one of claims 8 to 10.

12. A camera module comprising the cured product of claim 11.
